# EUROPEAN PATENT APPLICATION

(11) **EP 4 704 507 A1**
(43) Date of publication of application: **04.03.2026**
(21) Application number: 24796821.7
(22) Date of filing: 11.04.2024
(51) Int. Cl.: H05K 7/20, B60H 1/00, H04N 23/52

(54) **COOLING DEVICE, CONTROL METHOD, AND COMPUTER PROGRAM**

(30) Priority: 27.04.2023 JP 2023073495
(71) Applicant: Magna Electronics Sweden AB, 447 37 Vårgårda (SE)
(72) Inventor: IWANO, Shota, Yokohama-shi, Kanagawa 222-0033 (JP); MIZUNO, Hidemichi, Yokohama-shi, Kanagawa 222-0033 (JP); JOJIKI, Reiko, Yokohama-shi, Kanagawa 222-0033 (JP); ITO, Takashi, Yokohama-shi, Kanagawa 222-0033 (JP)
(74) Representative: Müller Verweyen
(86) International application number: PCT/JP2024/014721
(87) International publication number: WO 2024/225065

(57) **Abstract**

To provide a cooling device, a control method, and a computer program that make it possible to cool a heat source such as an ADAS device in a vehicle. A cooling device for cooling a heat source in a vehicle, including:
a ventilator; and
a voltage supply part that supplies voltage to the ventilator, where
the voltage supply part supplies a voltage for rotating the ventilator to the ventilator, and when the rotational speed of the ventilator does not exceed a prescribed rotational speed, repeatedly performs supplying of the voltage to the ventilator and stopping of the supplying of the voltage.

## Description

### TECHNICAL FIELD

The present invention relates to a cooling device, a control method, and a computer program for cooling a heat source such as an ADAS device mounted on a vehicle.

### BACKGROUND TECHNOLOGY

In order to achieve safe driving of vehicles, an Advanced Driver Assistance System (ADAS) has been developed. ADAS uses sensors such as cameras or radar to measure conditions outside the vehicle and assists the driver in driving depending on the conditions. For example, the brake and accelerator may be controlled to maintain a safe distance between vehicles, a warning may be issued when there is a risk of collision, or the brakes may be applied immediately before a collision occurs. Hereinafter, a device provided in a vehicle to achieve the ADAS function will be referred to as an ADAS device. When an ADAS device operates, it generates heat and requires cooling. Patent Document 1 discloses an example of an ADAS device equipped with a camera and a ventilator for cooling.

### RELATED ART DOCUMENTS

### PATENT DOCUMENTS

Patent Document 1: Japanese PCT Patent Application Publication 2022-546749

### SUMMARY OF THE INVENTION

### PROBLEM TO BE SOLVED BY THE INVENTION

ADAS devices are often installed inside the vehicle cabin of a vehicle. Ventilators for cooling an ADAS device can be a source of noise. One way to reduce noise is to stop the ventilator when the ventilator is not needed. However, after the ventilator has been turned off for an extended period of time, the ventilator bearings may seize, causing the ventilator to stop rotating and fail to provide cooling for the ADAS device when needed. In addition to the ventilator for cooling the ADAS device, the vehicle is also provided with ventilators for cooling other heat sources. Similar problems can occur with these ventilators.

In light of the above circumstances, an object of the present invention is to provide a cooling device, a control method, and a computer program that make it possible to cool a heat source such as an ADAS device inside a vehicle.

### MEANS FOR SOLVING THE PROBLEM

A cooling device according to one aspect of the present invention for a cooling device for cooling a heat source in a vehicle includes:
a ventilator; and
a voltage supply part that supplies voltage to the ventilator, wherein
the voltage supply part supplies a voltage for rotating the ventilator to the ventilator, and when the rotational speed of the ventilator does not exceed a prescribed rotational speed, repeatedly performs supplying of the voltage to the ventilator and stopping of the supplying of the voltage.

A control method according to one aspect of the present invention includes:
supplying a voltage for rotating a ventilator to the ventilator for cooling a heat source in a vehicle; and
repeating supply of the voltage to the ventilator and stopping supply of voltage when a rotational speed of the ventilator does not exceed a prescribed rotational speed.

A computer program according to one aspect of the present invention includes:
causing a voltage supply part to supply voltage for rotating a ventilator to the ventilator for cooling a heat source in a vehicle, and
causing the voltage supply part to repeatedly supply voltage and stop supply of voltage to the ventilator if the rotation speed of the ventilator does not exceed a prescribed rotation speed.

In one embodiment of the present invention, a voltage for rotating a ventilator is supplied to the ventilator, and when the rotation speed of the ventilator does not exceed a prescribed rotation speed and the ventilator does not rotate, the supply of voltage to the ventilator is repeated. By repeatedly supplying voltage to the ventilator when the ventilator is not rotating, sticking of the bearings is resolved, allowing the ventilator to rotate and cool the heat source, such as the ADAS device.

### EFFECT OF THE INVENTION

The present invention has excellent effects, such as being able to rotate the ventilator when necessary to cool the ADAS device even after the ventilator has been stopped for a long period of time.

### BRIEF DESCRIPTION OF THE DRAWINGS

FIG. 1 is a schematic block diagram depicting an example of a vehicle equipped with an ADAS device;
FIG. 2 is a block diagram depicting an example of the internal configuration of the ADAS device;
FIG. 3 is a perspective view depicting an example of the appearance of the ADAS device;
FIG. 4 is a perspective view depicting an example of the appearance of the ADAS device;
FIG. 5 is a perspective view depicting an example of the inside of the ADAS device;
FIG. 6 is a block diagram depicting an example of the internal configuration of a control unit;
FIG. 7 is a schematic cross-sectional view depicting an example of the configuration of a ventilator;
FIG. 8 is a flowchart depicting an example of a procedure for a process for cooling an ADAS device executed by a cooling device;
FIG. 9 is a flowchart depicting an example of a processing procedure for preventing the ventilator from stopping rotation;
FIG. 10 is a block diagram depicting an example of the internal configuration of an ADAS device having an internal power source;
FIG. 11 is a schematic block diagram depicting an example of a vehicle according to Embodiment 2;
FIG. 12 is a block diagram depicting an example of the internal configuration of a computing device including a cooling device;
FIG. 13 is a block diagram depicting an example of the configuration of a cooling device that cools vehicle equipment; and
FIG. 14 is a block diagram depicting an example of the configuration of a cooling device configured using a ventilator for achieving the functions of vehicle equipment.

### DESCRIPTION OF THE PREFERRED EMBODIMENTS

The present invention will now be described in detail with reference to the drawings depicting embodiments thereof.

### <Embodiment 1>

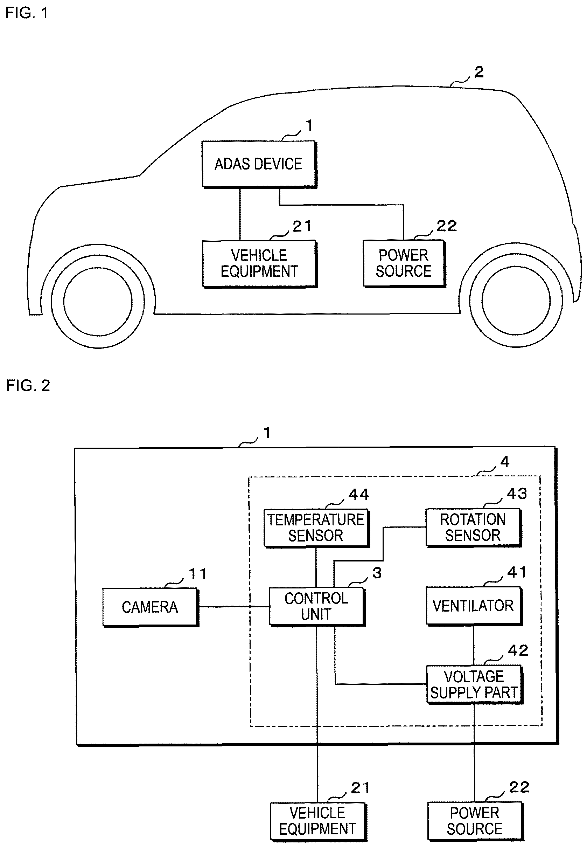

FIG. 1 is a schematic block diagram depicting an example of a vehicle 2 equipped with an ADAS device 1. The ADAS device 1 is a device for achieving the functions of an ADAS. The vehicle 2 is equipped with the ADAS device 1, vehicle equipment 21, and a power source 22. The vehicle equipment 21 is various types of equipment mounted on the vehicle 2. For example, the vehicle equipment 21 may include a control device that controls the drive mechanism of the vehicle 2, such as the engine or steering, electrical equipment such as audio or a display, or various sensors such as an engine tachometer or speedometer. The power source 22 includes a battery and supplies power to electrical equipment within the vehicle 2. For example, the ADAS device 1 is disposed inside the vehicle cabin, near the ceiling and the windshield.

FIG. 2 is a block diagram depicting an example of the internal configuration of the ADAS device 1. The ADAS device 1 includes a control unit 3, a camera 11, a ventilator 41, a voltage supply part 42, a temperature sensor 44, and a rotation sensor 43. The camera 11 generates an image obtained by capturing of the outside of the vehicle 2. The ventilator 41 generates wind and emits air for cooling the ADAS device 1 by rotating an impeller. The ventilator 41 emits air to cool, in particular, the control unit 3.

The voltage supply part 42 is composed of a circuit that converts and supplies power. The voltage supply part 42 receives power from the power source 22 and supplies voltage to the ventilator 41 for rotating the ventilator 41. For example, the voltage supply part 42 supplies a constant voltage corresponding to a desired rotation speed to the ventilator 41. The ventilator 41 is rotated based on the voltage supplied from the voltage supply part 42. The rotation sensor 43 measures the rotation speed of the ventilator 41. Here, the rotation speed is the number of rotations per unit time. For example, the rotation sensor 43 measures the rotation speed of the ventilator 41 using magnetism or light. The temperature sensor 44 is configured using, for example, a thermistor. The temperature sensor 44 measures the temperature of a prescribed portion within the ADAS device 1. For example, the temperature sensor 44 measures the temperature in the vicinity of the control unit 3.

The camera 11, the voltage supply part 42, the temperature sensor 44 and the rotation sensor 43 are connected to the control unit 3. The control unit 3 controls the operation of each part of the ADAS device 1. The control unit 3 is also connected to vehicle equipment 21. The control unit 3 acquires an image generated by the camera 11 and controls operation of the vehicle 2 by transmitting a control signal to the vehicle equipment 21 based on the image. For example, the control unit 3 determines the distance between vehicles based on the image generated by the camera 11, and transmits a control signal to the vehicle equipment 21 to control the brake and accelerator so as to maintain the distance between vehicles. Furthermore, the control unit 3 controls the voltage supply part 42 to execute a control method for controlling operation of the ventilator 41. The control unit 3, the ventilator 41, the voltage supply part 42, the temperature sensor 44 and the rotation sensor 43 constitute a cooling device 4.

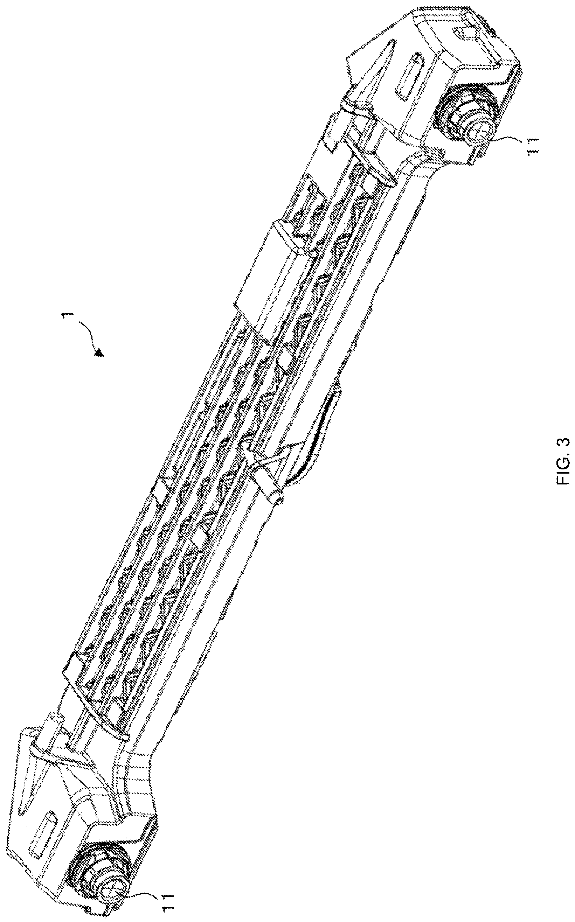

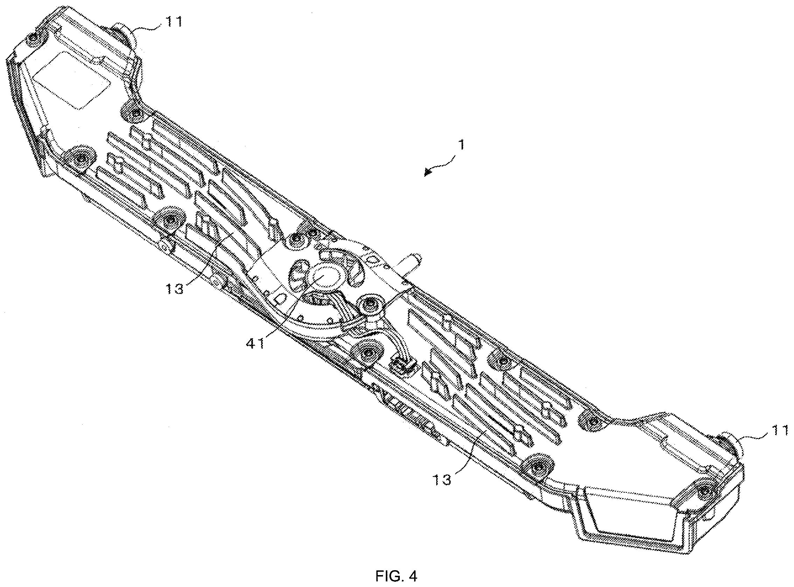

FIG. 3 and FIG. 4 are perspective views depicting examples of the appearance of the ADAS device 1. FIG. 4 depicts the back side of the ADAS device 1 depicted in FIG. 3. The ADAS device 1 is arranged so that the camera 11 is directed in the forward direction of the vehicle 2. As depicted in FIG. 4, the ADAS device 1 includes a heat sink 13, and the ventilator 41 is disposed so as to be able to blow air to the heat sink 13.

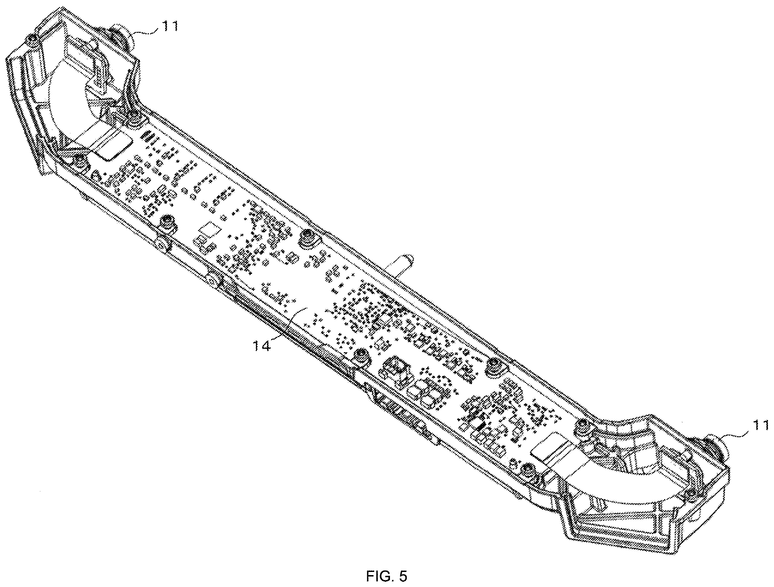

FIG. 5 is a perspective view depicting an example of the inside of the ADAS device 1. FIG. 5 depicts the ADAS device 1 depicted in FIG. 4 with the ventilator 41, the heat sink 13, and a part of the housing of the ADAS device 1 removed. The ADAS device 1 has a circuit board 14. The control unit 3 is mounted on the circuit board 14. The voltage supply part 42, temperature sensor 44 and rotation sensor 43 are also mounted on the circuit board 14. For example, the temperature sensor 44 measures the temperature of the circuit board 14 on which the control unit 3 is mounted. The camera 11, the voltage supply part 42, the temperature sensor 44 and the rotation sensor 43 are connected to the control unit 3 via a circuit provided on the circuit board 14.

The heat sink 13 is disposed so that heat is transferred from the circuit board 14 and heat dissipation is promoted. Heat generated by operation of the ADAS device 1 is transferred from the circuit board 14 to the heat sink 13, and the ventilator 41 blows air to the heat sink 13, further promoting heat dissipation. In this manner, the ADAS device 1 is cooled. In particular, the control unit 3 mounted on the circuit board 14 is cooled. The configuration of the ADAS device 1 depicted in FIG. 3 to FIG. 5 is an example, and the ventilator 41 may be arranged in any manner to cool the ADAS device 1.

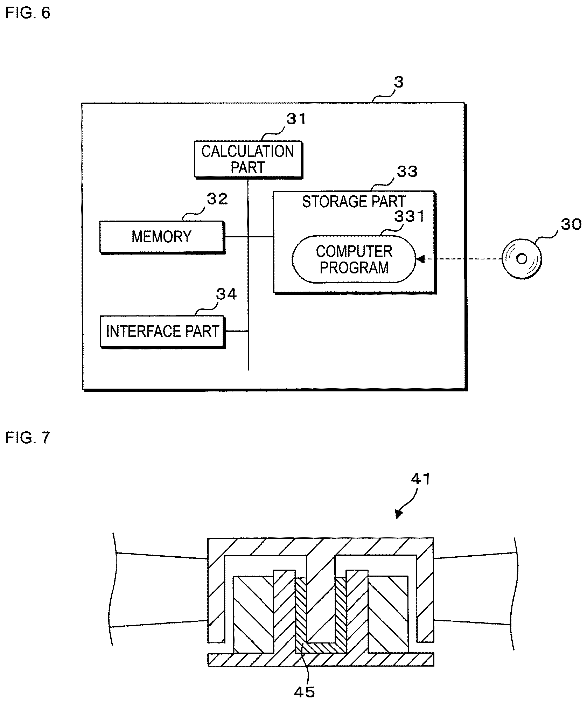

FIG. 6 is a block diagram depicting an example of the internal configuration of the control unit 3. The control unit 3 is configured using a computer such as an ECU (Electronic Control Unit). The control unit 3 includes a calculation part 31, a memory 32, a storage part 33, and an interface part 34. The calculation part 31 is configured using, for example, a CPU (Central Processing Unit), a GPU (Graphics Processing Unit), or a multi-core CPU. The calculation part 31 may be configured using a quantum computer. The memory 32 stores programs or temporary data generated during calculations. The memory 32 is, for example, RAM (Random Access Memory). The storage part 33 is nonvolatile, and is, for example, a hard disk or nonvolatile semiconductor memory. The interface part 34 is connected to the camera 11, the voltage supply part 42, the temperature sensor 44, the rotation sensor 43, and the vehicle equipment 21, and transmits and receives data to and from each part.

The storage part 33 stores a computer program (program product) 331. For example, when the control unit 3 is manufactured, the computer program 331 is read from recording media 30 such as an optical disk or a portable memory that stores the computer program 331, and stored in the storage part 33. The computer program 331 may be downloaded from outside the control unit 3 and stored in the storage part 33. The calculation part 31 executes necessary information processing in accordance with a computer program 331. That is, the control unit 3 is a computer that executes processing in accordance with the computer program 331. The control unit 3 may be configured by a plurality of computers connected to each other, and the computer program 331 may be executed on a plurality of computers. Note that the control unit 3 may be configured using a logic circuit such as an ASIC (Application Specific Integrated Circuit) or an FPGA (Field Programmable Gate Array) instead of a calculation part that uses a computer program.

FIG. 7 is a schematic cross-sectional view depicting an example of the configuration of the ventilator 41. FIG. 7 depicts a cross section of the central portion of the ventilator 41 including the bearings. The ventilator 41 has an oil bearing 45 as a bearing. The oil bearing 45 is a type of fluid bearing, and uses oil as the fluid that supports the rotating shaft. Since the ADAS device 1 is disposed inside the vehicle cabin, the noise generated by the ventilator 41 reaches the ears of the passengers of the vehicle 2 and adversely affects the passengers. By using the oil bearing 45, the noise generated by rotation of the ventilator 41 is reduced.

If the ventilator 41 rotates constantly, noise from the ventilator 41 will continue and deterioration of the ventilator 41 will progress, so it is desirable to stop the ventilator 41 except when the ADAS device 1 needs to be cooled. However, if the ventilator 41 is stopped for a long period of time, the oil used in the oil bearing 45 may absorb moisture and solidify, causing the oil bearing 45 to stick. If the oil bearing 45 becomes stuck, the ventilator 41 will not rotate and it will not be possible to cool the ADAS device 1.

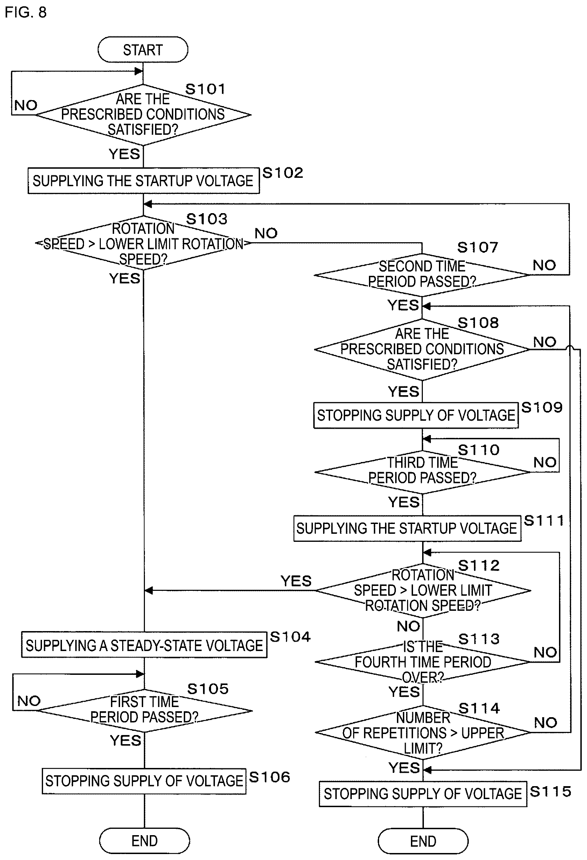

The cooling device 4 operates in such a way that it is possible to cool the ADAS device 1 when necessary. FIG. 8 is a flowchart depicting an example of a procedure for a process for cooling the ADAS device 1 executed by the cooling device 4. Hereinafter, step will be abbreviated as S. The calculation part 31 executes information processing in accordance with the computer program 331, and the control unit 3 executes the following processing.

The control unit 3 determines whether or not a prescribed condition is satisfied (S101). The prescribed condition is that prescribed equipment provided in the vehicle 2 is operating and the temperature measured by the temperature sensor 44 exceeds a prescribed temperature. The prescribed equipment is equipment that generates noise among the equipment provided in the vehicle 2, such as an engine or audio equipment. For example, the control unit 3 acquires the engine rotation speed measured by an engine tachometer included in the vehicle equipment 21, and determines that the engine is operating if the engine rotation speed exceeds a prescribed rotation speed. For example, the control unit 3 acquires the speed of the vehicle 2 measured by a speedometer included in the vehicle equipment 21, and determines that the engine is operating if the speed of the vehicle 2 exceeds a prescribed speed. For example, the control unit 3 receives an operation signal from the audio included in the vehicle equipment 21, and thereby determines that the audio is operating.

The control unit 3 acquires the temperature measured by the temperature sensor 44 and determines whether the acquired temperature exceeds a prescribed temperature. The prescribed temperature is stored in advance in the storage part 33 or is included in the computer program 331. The control unit 3 operates the ventilator 41 when a prescribed condition is satisfied. As a result, when a prescribed portion of the ADAS device 1 exceeds a prescribed temperature, in other words, when the temperature of the ADAS device 1 is high and cooling of the ADAS device 1 is required, the ventilator 41 operates and the ADAS device 1 is cooled. Furthermore, when other noise-generating equipment is operating in addition to the ventilator 41, the ventilator 41 operates. In a state where noise is already being generated, even if noise is generated from the ventilator 41, the adverse effects of the noise from the ventilator 41 are suppressed.

If the prescribed condition is not satisfied (S101: NO), the control unit 3 repeats the process of S101. If the prescribed condition is satisfied (S101: YES), the control unit 3 causes the voltage supply part 42 to supply a startup voltage to the ventilator 41 (S102). The startup voltage is a voltage for starting the rotation of the ventilator 41. The startup voltage is determined beforehand. In S102, the control unit 3 causes the voltage supply part 42 to supply the startup voltage to the ventilator 41 by transmitting a control signal to the voltage supply part 42 to instruct the voltage supply part to supply the startup voltage to the ventilator 41. The voltage supply part 42 supplies a startup voltage to the ventilator 41 in accordance with the control signal. When the oil bearing 45 is not stuck, the ventilator 41 starts to rotate when a startup voltage is supplied. If the oil bearing 45 is stuck, the ventilator 41 may not be able to start rotating.

The control unit 3 determines whether the rotation speed of the ventilator 41 exceeds a prescribed lower limit rotation speed (S103). In S103, the control unit 3 acquires the rotation speed of the ventilator 41 measured by the rotation sensor 43, and determines whether the rotation speed exceeds the lower limit rotation speed. The lower limit rotation speed is stored in advance in the storage part 33 or is included in the computer program 331. When the rotation speed of the ventilator 41 exceeds the lower limit rotation speed, the ventilator 41 has started to rotate, and when the rotation speed of the ventilator 41 does not exceed the lower limit rotation speed, the ventilator 41 has not started to rotate.

If the rotation speed of the ventilator 41 exceeds the lower limit rotation speed (S103: YES), the control unit 3 causes the voltage supply part 42 to supply a steady-state voltage to the ventilator 41 (S104). In S104, the control unit 3 causes the voltage supply part 42 to supply a steady-state voltage to the ventilator 41 by transmitting a control signal to the voltage supply part 42 to instruct the voltage supply part to supply a steady-state voltage to the ventilator 41. The voltage supply part 42 supplies a steady-state voltage to the ventilator 41 in accordance with the control signal. The process from S104 onwards is carried out when the ventilator 41 has started rotating. The steady-state voltage is a voltage for rotating the ventilator 41 continuously. The steady-state voltage is determined beforehand. For example, the steady-state voltage is a voltage that is lower than the startup voltage. The ventilator 41 supplied with a steady-state voltage rotates continuously. The ventilator 41 may rotate continuously or intermittently. The control unit 3 may perform a process for supplying a steady-state voltage to the ventilator 41 when the rotation speed of the ventilator 41 is equal to or higher than the lower limit rotation speed.

The control unit 3 determines whether a prescribed first time period has elapsed since the supply of steady-state voltage to the ventilator 41 started (S105). The first time period is a time period sufficient for cooling the ADAS device 1 based on the air blown from the ventilator 41, and is determined beforehand. If the first time period has not yet elapsed (S105: NO), the control unit 3 repeats the process of S105. If the first time period has elapsed (S105: YES), the control unit 3 causes the voltage supply part 42 to stop supplying voltage to the ventilator 41 (S106), and ends the process. In S106, the control unit 3 causes the voltage supply part 42 to stop supplying voltage to the ventilator 41 by sending a control signal to the voltage supply part 42 instructing the voltage supply part to stop supplying voltage to the ventilator 41. The voltage supply part 42 stops supplying voltage to the ventilator 41 in accordance with the control signal. Note that instead of steps S105 and S106, the control unit 3 may perform a process to continue supplying voltage to the ventilator 41 until the temperature measured by the temperature sensor 44 reaches a prescribed temperature that is sufficiently low.

If the rotation speed of the ventilator 41 does not exceed the lower limit rotation speed (S103: NO), the control unit 3 determines whether a prescribed second time period has elapsed since the supply of the startup voltage to the ventilator 41 was started (S107). The process from S107 onwards is carried out when the ventilator 41 has not yet started rotating. The second time period is determined beforehand and is, for example, about one second. If the second time period has not yet elapsed (S107: NO), the control unit 3 returns processing to S103. If the second time period has elapsed (S107: YES), the control unit 3 determines whether a prescribed condition is satisfied (S108). In S108, the control unit 3 performs the same process as in S101. The control unit 3 may omit the process of S108.

If the prescribed condition is satisfied (S108: YES), the control unit 3 causes the voltage supply part 42 to stop supplying voltage to the ventilator 41 (S109). In S109, the control unit 3 causes the voltage supply part 42 to stop supplying voltage by transmitting a control signal to the voltage supply part 42 instructing the voltage supply part to stop supplying voltage. The voltage supply part 42 stops supplying voltage to the ventilator 41 in accordance with the control signal. The control unit 3 determines whether a prescribed third time period has elapsed since the supply of voltage was stopped (S110). The third time period is determined beforehand and is, for example, about one second. If the third time period has not yet elapsed (S110: NO), the control unit 3 repeats the process of S110.

If the third time period has elapsed (S110: YES), the control unit 3 causes the voltage supply part 42 to supply the startup voltage to the ventilator 41 (S111). In S111, the control unit 3 causes the voltage supply part 42 to supply the startup voltage to the ventilator 41 by transmitting a control signal to the voltage supply part 42 to instruct the voltage supply part to supply the startup voltage to the ventilator 41. The voltage supply part 42 supplies a startup voltage to the ventilator 41 in accordance with the control signal. The control unit 3 determines whether the rotation speed of the ventilator 41 exceeds the lower limit rotation speed (S112). If the rotation speed of the ventilator 41 exceeds the lower limit rotation speed (S112: YES), the control unit 3 advances the processing to S104. A state where the rotation speed of the ventilator 41 exceeds the lower limit rotation speed means the lock on the oil bearing 45 has been released and the ventilator 41 starts to rotate.

If the rotation speed of the ventilator 41 does not exceed the lower limit rotation speed (S112: NO), the control unit 3 determines whether a prescribed fourth time period has elapsed since the supply of the startup voltage to the ventilator 41 started (S113). The fourth time period is determined beforehand, and for example, the fourth time period has the same length as the second time period. If the fourth time period has not yet elapsed (S113: NO), the control unit 3 returns processing to S112.

If the fourth time period has elapsed (S113: YES), the control unit 3 determines whether the number of times that the startup voltage has been repeatedly supplied to the ventilator 41 exceeds a prescribed upper limit (S114). The upper limit value is stored in advance in the storage part 33 or is included in the computer program 331. In S114, the control unit 3 may determine whether the number of repetitions is equal to or greater than an upper limit. If the number of repetitions does not exceed the upper limit (S114: NO), the control unit 3 returns processing to S108.

By repeating the processes of S108 to S114, the control unit 3 repeatedly supplies and stops the supply of voltage to the ventilator 41 at prescribed intervals. As a result, when the oil bearing 45 is stuck and the ventilator 41 cannot start rotating, the startup voltage is repeatedly supplied to the ventilator 41 at prescribed intervals. When a startup voltage is supplied to the ventilator 41, the ventilator 41 tries to start rotating, and an impact is applied to the oil bearing 45. By repeatedly applying impacts to the oil bearing 45, the adhesion of the oil bearing 45 may be released, and the ventilator 41 may be able to rotate. Therefore, the control unit 3 repeats the processes of S108 to S114, causing the ventilator 41 to rotate, and making it possible to cool the ADAS device 1.

If the number of times that the startup voltage has been repeatedly supplied to the ventilator 41 exceeds the upper limit (S114: YES), the control unit 3 causes the voltage supply part 42 to stop supplying voltage to the ventilator 41 (S115) and terminates the processing. In S115, the control unit 3 causes the voltage supply part 42 to stop supplying voltage by transmitting a control signal to the voltage supply part 42 instructing the voltage supply part to stop supplying voltage. The voltage supply part 42 stops supplying voltage to the ventilator 41 in accordance with the control signal. The control unit 3 may perform error processing when terminating the processing. For example, the control unit 3 may perform error processing to notify that the ventilator 41 does not rotate or is unable to cool the ADAS device 1. Alternatively, the control unit 3 may perform error processing so as not to perform processing for ADAS.

Note that the control unit 3 may omit the process of S114. In this aspect, the control unit 3 returns the process to S108 when the fourth time period has elapsed in S113. In this aspect, the supply of the startup voltage to the ventilator 41 is repeated until the ventilator 41 is able to rotate.

As described above, when it is necessary to cool the ADAS device 1, the cooling device 4 supplies voltage to the ventilator 41 to rotate the ventilator 41, and when the ventilator 41 does not rotate, the cooling device repeats supplying of voltage to the ventilator 41. When cooling is required, a voltage is supplied to the ventilator 41, causing the ventilator 41 to rotate and cool the ADAS device 1. If the oil bearing 45 of the ventilator 41 is stuck, the ventilator 41 will not rotate. By repeatedly supplying voltage to the ventilator 41 when the ventilator 41 is not rotating, the adhesion of the oil bearing 45 is resolved, allowing the ventilator 41 to rotate and cooling the ADAS device 1. Therefore, even after the ventilator 41 has been stopped for a long period of time, the cooling device 4 can rotate the ventilator 41 when necessary to cool the ADAS device 1. Stopping the ventilator 41 becomes feasible, and the noise caused by the ventilator 41 can be reduced. Therefore, the cooling device 4 can cool the ADAS device 1 when necessary while reducing noise.

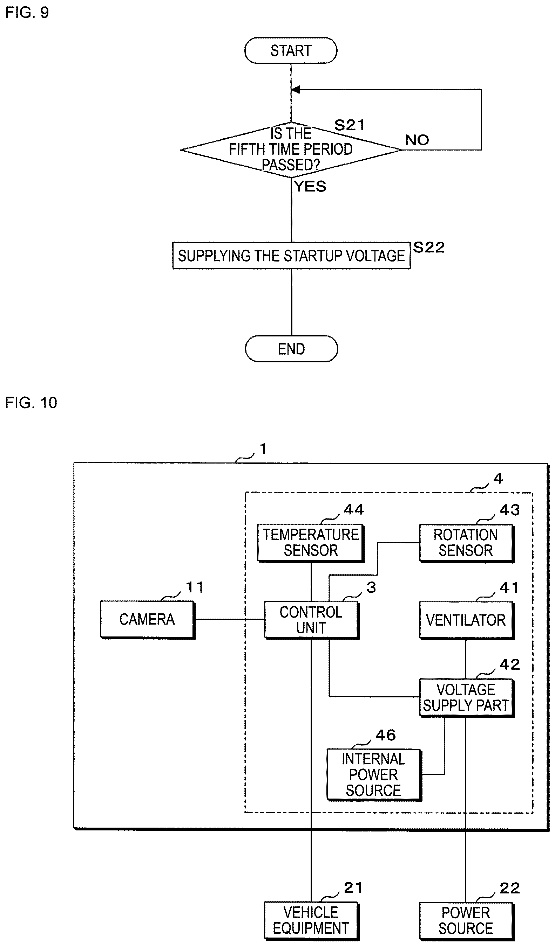

In the processes of S101 to S115, the cooling device 4 rotates the ventilator 41 to cool the ADAS device 1 when a prescribed condition is met. If the prescribed conditions are not satisfied for a long period of time, the oil bearing 45 of the ventilator 41 may become stuck, causing the ventilator 41 to stop rotating and making it impossible to cool the ADAS device 1. The cooling device 4 operates to prevent the ventilator 41 from stopping rotation. FIG. 9 is a flowchart depicting an example of a processing procedure for preventing the ventilator 41 from stopping rotation. The calculation part 31 executes information processing in accordance with the computer program 331, and the control unit 3 executes the following processing.

The control unit 3 determines whether a prescribed fifth time period has elapsed since the supply of voltage to the ventilator 41 was stopped while a prescribed condition was not satisfied (S21). The prescribed conditions are the same as those in S101 and S108. The fifth time period is determined beforehand to be shorter than the time required for the oil used in the oil bearing 45 to solidify while the ventilator 41 is not rotating. For example, the fifth time period is about one day. If the fifth time period has not yet elapsed (S21: NO), the control unit 3 repeats the process of S21.

If the fifth time period has elapsed (S21: YES), the control unit 3 causes the voltage supply part 42 to supply the startup voltage to the ventilator 41 (S22). In S22, the control unit 3 causes the voltage supply part 42 to supply the startup voltage by transmitting a control signal to the voltage supply part 42 to instruct the voltage supply part to supply the startup voltage. The voltage supply part 42 supplies a startup voltage to the ventilator 41 in accordance with the control signal. The ventilator 41 rotates when supplied with a startup voltage.

The ADAS device 1 may be configured to use an internal power source. FIG. 10 is a block diagram depicting an example of the internal configuration of an ADAS device 1 having an internal power source 46. The ADAS device 1 is equipped with an internal power source 46 such as a storage battery. The internal power source 46 is connected to the voltage supply part 42. With this aspect, in S22, the control unit 3 causes the internal power source 46 to supply a startup voltage to the ventilator 41. The control unit 3 sends a control signal to the voltage supply part 42 to instruct the voltage supply part to supply the startup voltage, thereby causing the voltage supply part 42 to supply the startup voltage from the internal power source 46 to the ventilator 41.

After S22, if the rotation speed of the ventilator 41 exceeds the lower limit rotation speed, the control unit 3 sends a control signal to the voltage supply part 42 instructing the voltage supply part to stop supplying voltage, thereby causing the voltage supply part 42 to stop supplying the startup voltage to the ventilator 41 and ending the processing. The voltage supply part 42 stops supplying voltage to the ventilator 41 in accordance with the control signal. After S22, the control unit 3 may supply voltage to the ventilator 41 for a prescribed time period, and then cause the voltage supply part 42 to stop supplying voltage to the ventilator 41, thereby ending the process. After S22, if the rotation speed of the ventilator 41 does not exceed the lower limit rotation speed, the control unit 3 may repeat supplying voltage to the ventilator 41. Alternatively, the control unit 3 may execute the processes from S103 onwards after S22.

As described above, the cooling device 4 periodically rotates the ventilator 41 when the prescribed conditions for rotating the ventilator 41 are not met, such as when the temperature of the ADAS device 1 is high and prescribed equipment inside the vehicle 2 is operating. By periodically rotating the ventilator 41, sticking of the oil bearing 45 is prevented, thereby preventing the ventilator 41 from failing to rotate when needed and preventing loss of cooling of the ADAS device 1. Therefore, when necessary, the ventilator 41 rotates, and the ADAS device 1 is reliably cooled. Therefore, the ADAS device 1 can stably achieve ADAS.

In the present Embodiment, the ADAS device 1 is an integrated device, but the ADAS device 1 may be configured as a combination of a plurality of devices that are separated from each other. For example, the camera 11 may be arranged near the ceiling in the vehicle cabin, the control unit 3 may be arranged under the seat, and the camera 11 may be connected to the control unit 3.

In the present Embodiment, the control unit 3 executes both the processing for ADAS and the processing for controlling operation of the ventilator 41. Alternatively, the ADAS device 1 may be configured to include a control unit that performs processing for controlling operation of the ventilator 41, separate from the control unit that performs processing for ADAS. The present Embodiment indicates an aspect where the cooling device 4 is included in the ADAS device 1, but the aspect may have the cooling device 4 arranged outside the ADAS device 1 and blow air from the outside to the ADAS device 1 to cool the ADAS device 1.

### <Embodiment 2>

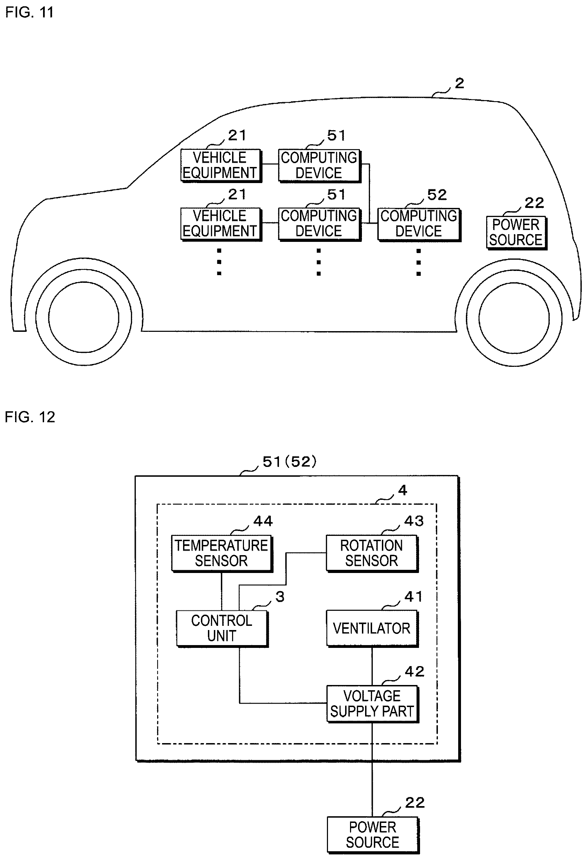

In addition to the ADAS device 1, various other heat sources exist within the vehicle 2. In Embodiment 2, examples of cooling various heat sources will be described. FIG. 11 is a schematic block diagram depicting an example of a vehicle 2 according to Embodiment 2. The vehicle 2 is equipped with a plurality of computing devices 51 that perform calculations to control a plurality of pieces of vehicle equipment 21. One computing device 51 is connected to one piece of vehicle equipment 21 and controls the vehicle equipment 21. There may be a computing device 51 that controls a plurality of pieces of vehicle equipment 21. The vehicle 2 includes a computing device 52 that communicates with a plurality of computing devices 51. A plurality of computing devices 51 are connected to the computing device 52. The vehicle 2 may include a plurality of computing devices 52, and the computing devices 52 may communicate with other computing devices 52. The vehicle 2 may be provided with a computing device that has both the functions of the computing device 51 and the computing device 52. The vehicle 2 also includes a power source 22.

The computing device 51 and the computing device 52 are ECUs. For example, the vehicle equipment 21 is an ADAS device, and the computing device 51 is an ADAS-ECU that controls the ADAS device 1. For example, the vehicle equipment 21 is equipment used for autonomous driving, and the computing device 51 is an AD (Autonomous Driving) ECU. For example, the vehicle equipment 21 is a radar, and the computing device 51 is a radar ECU. For example, the vehicle equipment 21 is a camera, and the computing device 51 is a camera ECU. For example, the vehicle equipment 21 is an engine of the vehicle 2, and the computing device 51 is an engine ECU. For example, the vehicle equipment 21 is a drive motor of the vehicle 2, and the computing device 51 is a motor ECU. For example, the vehicle equipment 21 is an airbag, and the computing device 51 is an airbag ECU. For example, the vehicle equipment 21 is power steering, and the computing device 51 is a power steering ECU. For example, the vehicle equipment 21 is a transmission, and the computing device 51 is a transmission control ECU.

For example, the vehicle equipment 21 is an air conditioner, and the computing device 51 is an air conditioner ECU. For example, the vehicle equipment 21 is an infotainment device such as a navigation device, and the computing device 51 is an ECU that controls the infotainment device. For example, the vehicle equipment 21 is equipment that performs seat ventilation, and the computing device 51 is an ECU that controls the equipment. For example, the vehicle equipment 21 is an air purifier, and the computing device 51 is an ECU that controls the air purifier. For example, the computing device 51 is a power charge control ECU that controls charging of a storage battery (not depicted) provided in the vehicle 2.

For example, the computing device 52 is a gateway ECU. For example, the computing device 52 is a map positioning unit (MPU) that calculates the position of the vehicle 2 and transmits information regarding the position to the computing device 51 or another computing device 52. For example, the computing device 52 is an OTA (Over-The-Air)-ECU that receives data for updating software used in the computing device 51 and the computing device 52 via wireless communication and updates the software of the computing device 51 or another computing device 52 using the received data. For example, the computing device 52 is a CCU (Central Computing Unit) that includes all or part of the examples of the computing devices 51 and the computing devices 52 described above.

In Embodiment 2, the cooling device 4 cools the computing device 51 or the computing device 52. FIG. 12 is a block diagram depicting an example of the internal configuration of the computing device 51 or computing device 52 including the cooling device 4. The computing device 51 includes a control unit 3, a ventilator 41, a voltage supply part 42, a temperature sensor 44, and a rotation sensor 43. The control unit 3 performs calculations to achieve the functions of the computing device 51. The internal configuration of the control unit 3 is the same as that of the control unit 3 in Embodiment 1 described with reference to FIG. 6. The control unit 3 is a heat source. The ventilator 41 generates wind by rotating an impeller, thereby cooling the control unit 3.

The voltage supply part 42 receives power from the power source 22 and supplies voltage to the ventilator 41 for rotating the ventilator 41. The rotation sensor 43 measures the rotation speed of the ventilator 41. The temperature sensor 44 measures the temperature of a prescribed portion inside the computing device 51. For example, the temperature sensor 44 measures the temperature of the control unit 3 or the temperature in the vicinity of the control unit 3. The voltage supply part 42, the temperature sensor 44 and the rotation sensor 43 are connected to the control unit 3. The control unit 3 controls operations of the voltage supply part 42, the temperature sensor 44 and the rotation sensor 43. The control unit 3, the ventilator 41, the voltage supply part 42, the temperature sensor 44 and the rotation sensor 43 constitute a cooling device 4.

The cooling device 4 executes the processes of S101 to S115 in the same manner as in Embodiment 1. The first time period is a time period sufficient for cooling the control unit 3 by the air blown from the ventilator 41, and is determined in advance. By executing the processes of S101 to S115, the cooling device 4 can cool the computing device 51 when necessary while reducing noise. In addition, the control unit 3 executes the processes of S21 and S22 in the same manner as in Embodiment 1. The computing device 51 may be provided with an internal power source, and the control unit 3 may perform the process of S22 using the internal power source. Based on processing of S21 to S22, the ventilator 41 is periodically rotated, thereby preventing the ventilator 41 from failing to rotate when needed and preventing cooling of the computing device 51 from becoming impossible.

As depicted in FIG. 12 with the reference numeral of the computing device 52 in parentheses, the internal configuration of the computing device 52 is the same as the internal configuration of the computing device 51. The control unit 3 performs calculations to achieve the functions of the computing device 52. In the computing device 52, similar to the computing device 51, the cooling device 4 executes the processes of S101 to S115, and the control unit 3 executes the processes of S21 and S22. By executing the processes of S101 to S115, the cooling device 4 can cool the computing device 52 when necessary while reducing noise.

FIG. 12 depicts an example in which the voltage supply part 42, the rotation sensor 43, and the temperature sensor 44 are connected to the control unit 3. Alternatively, the computing device 51 or the computing device 52 may be provided with a control unit, separate from the control unit 3, to which the voltage supply part 42, the rotation sensor 43, and the temperature sensor 44 are connected, and which controls operation of the voltage supply part 42. Although FIG. 12 depicts a configuration in which the cooling device 4 is included inside the computing device 51 or the computing device 52, the cooling device 4 may also be provided outside the computing device 51 or the computing device 52, and may cool the control unit 3 from outside the computing device 51 or the computing device 52.

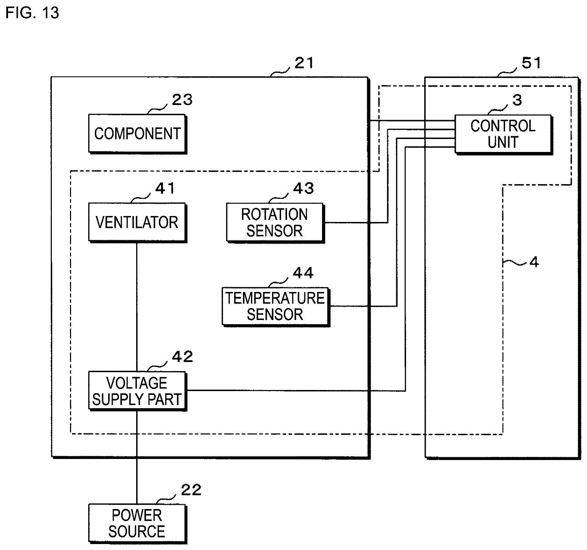

In Embodiment 2, the cooling device 4 may be configured to cool the vehicle equipment 21. FIG. 13 is a block diagram depicting an example of the configuration of the cooling device 4 that cools the vehicle equipment 21. The vehicle equipment 21 is connected to the computing device 51 that controls the vehicle equipment 21, and includes a component 23 that serves as a heat source. The vehicle equipment 21 includes a ventilator 41, a voltage supply part 42, a temperature sensor 44 and a rotation sensor 43. The ventilator 41 generates wind by rotating an impeller, thereby cooling the component 23.

The voltage supply part 42 receives power from the power source 22 and supplies voltage to the ventilator 41 for rotating the ventilator 41. The rotation sensor 43 measures the rotation speed of the ventilator 41. The temperature sensor 44 measures the temperature of a prescribed portion within the vehicle equipment 21. For example, the temperature sensor 44 measures the temperature of the component 23 or the temperature in the vicinity of the component 23. The voltage supply part 42, the temperature sensor 44 and the rotation sensor 43 are connected to the control unit 3 of the computing device 51 that controls the vehicle equipment 21. The control unit 3 controls operations of the voltage supply part 42, the temperature sensor 44 and the rotation sensor 43. The control unit 3, the ventilator 41, the voltage supply part 42, the temperature sensor 44 and the rotation sensor 43 constitute a cooling device 4.

The component 23 that serves as a heat source may be a member, or may be electronic equipment that is connected to and controlled by the control unit 3. For example, the vehicle equipment 21 is an infotainment device, and the component 23 is an electronic device within the infotainment device. For example, the vehicle equipment 21 is a camera, and the component 23 is a lens or an imaging element. For example, the vehicle equipment 21 is a power conversion device, and the component 23 is a DC (direct current)-DC converter. For example, the vehicle equipment 21 is an air purifier and the component 23 is a ventilator. The ventilator 41 cools the ventilator of the air purifier. For example, the vehicle equipment 21 is a light-emitting device such as a headlight, and the component 23 is a light-emitting element such as a high-power LED (light-emitting diode).

The cooling device 4 executes the processes of S101 to S115 in the same manner as in Embodiment 1. The first time period is a time period sufficient for the component 23 to be cooled by the air blown from the ventilator 41, and is determined beforehand. By executing the processes of S101 to S115, the cooling device 4 can cool the vehicle equipment 21 when necessary while reducing noise. In addition, the control unit 3 executes the processes of S21 and S22 in the same manner as in Embodiment 1. Based on processing of S21 to S22, the ventilator 41 is periodically rotated, thereby preventing the ventilator 41 from failing to rotate when needed and preventing cooling of the vehicle equipment 21 from becoming impossible.

FIG. 13 depicts an example in which the voltage supply part 42, the rotation sensor 43, and the temperature sensor 44 are connected to the control unit 3. Alternatively, the voltage supply part 42, the rotation sensor 43 and the temperature sensor 44 may not be connected to the control unit 3, and the vehicle equipment 21 may have a control unit to which the voltage supply part 42, the rotation sensor 43 and the temperature sensor 44 are connected and which controls operation of the voltage supply part 42. FIG. 13 depicts a cooling device 4 that includes part of the vehicle equipment 21 and part of the computing device 51, but the cooling device 4 may also be provided outside the vehicle equipment 21 and cool the component 23 from outside the vehicle equipment 21.

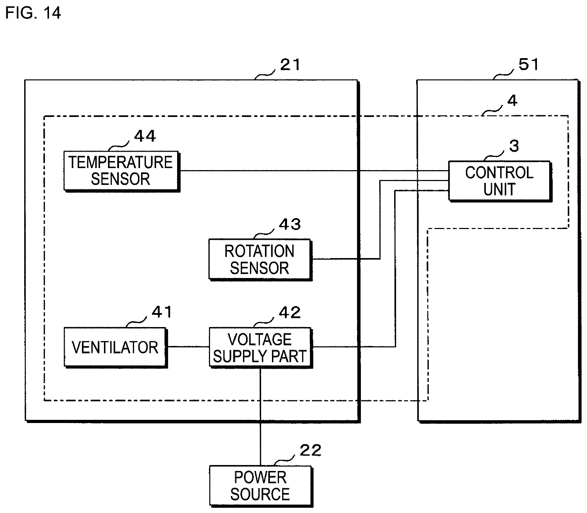

Some of the pieces of vehicle equipment 21 have a function of blowing air to cool a specific heat source. In Embodiment 2, when the vehicle equipment 21 is provided with a ventilator for achieving a function thereof, the cooling device 4 may be configured using the ventilator. FIG. 14 is a block diagram depicting an example of the configuration of the cooling device 4 that is configured using a ventilator 24 for achieving the functions of the vehicle equipment 21. The vehicle equipment 21 is connected to the computing device 51 and is controlled by the computing device 51. The vehicle equipment 21 includes a ventilator 24 for achieving the function of blowing air to cool a specific heat source. The ventilator 24 generates wind for cooling the heat source by rotating an impeller. The configuration of the ventilator 24 is similar to the configuration of the ventilator 41 described with reference to FIG. 7.

The vehicle equipment 21 includes voltage supply part 42, temperature sensor 44 and rotation sensor 43. The voltage supply part 42 receives power from the power source 22 and supplies voltage to the ventilator 41 for rotating the ventilator 41. The rotation sensor 43 measures the rotation speed of the ventilator 24. The temperature sensor 44 measures the temperature of the heat source or the temperature near the heat source. The voltage supply part 42, the temperature sensor 44 and the rotation sensor 43 are connected to the control unit 3 of the computing device 51 that controls the vehicle equipment 21. The control unit 3 controls operations of the voltage supply part 42, the temperature sensor 44 and the rotation sensor 43. The control unit 3 controls operation of the voltage supply part 42 to control the ventilator 24. The control unit 3, the ventilator 24, the voltage supply part 42, the temperature sensor 44 and the rotation sensor 43 constitute the cooling device 4.

The heat source to be cooled by the ventilator 24 may be located inside the vehicle equipment 21 or outside the vehicle equipment 21. For example, the vehicle equipment 21 is a radiator, the heat source is a heat sink included in the radiator, and the computing device 51 is an engine ECU. The ventilator 24 cools the heat sink, which is a heat source, by blowing air onto the heat sink. For example, the vehicle equipment 21 is an air conditioner, the ventilator 24 is a blower fan of the air conditioner, the heat source is the air inside the passenger compartment of the vehicle 2, and the computing device 51 is an air conditioner ECU. The ventilator 24 blows air into the passenger compartment of the vehicle 2 to cool the air in the passenger compartment, which is a heat source. For example, the vehicle equipment 21 is an air conditioner, the heat source is a condenser of the air conditioner, and the ventilator 24 is a condenser ventilator of the air conditioner. The ventilator 24 blows air to the condenser, thereby cooling the condenser, which is a heat source.

For example, the vehicle equipment 21 is a device that performs seat ventilation, the heat source is an occupant sitting in a seat of the vehicle 2, and the ventilator 24 blows air so as to suck out air between the seat and the passenger. The ventilator 24 sucks air between the seat and the occupant, thereby cooling the occupant, who is a heat source. For example, the vehicle equipment 21 is a cooling device that cools a storage battery provided in the vehicle 2, the heat source is the storage battery, the ventilator 24 is a cooling fan for cooling the storage battery, and the computing device 51 is a power charge control ECU. The ventilator 24 cools the storage battery, which is a heat source, by blowing air to the storage battery.

The cooling device 4 controls operation of the ventilator 24, in the same manner as controlling operation of the ventilator 41, by executing processing similar to steps S101 to S115. The first time period is a prescribed time period determined beforehand. By executing processes similar to S101 to S115, the cooling device 4 can cool the heat source when necessary while reducing noise. Furthermore, the control unit 3 controls operation of the ventilator 24 in the same manner as controlling operation of the ventilator 41 by executing processes similar to S21 and S22. Based on processing similar to S21 and S22, the ventilator 24 is periodically rotated, thereby preventing the ventilator 24 from failing to rotate when needed and preventing cooling of the heat source from becoming impossible.

In Embodiment 1 and 2, the prescribed condition for rotating the ventilator 41 is that prescribed equipment provided in the vehicle 2 is operating and the temperature measured by the temperature sensor 44 exceeds a prescribed temperature, but the content of the condition may be different. For example, the prescribed condition does not have to include a condition that prescribed equipment such as an engine provided in the vehicle 2 is operating.

In Embodiments 1 and 2, the rotation speed of the ventilator 41 or the ventilator 24 is measured by the rotation sensor 43, but the cooling device 4 may also be configured to acquire the rotation speed of the ventilator 41 or the ventilator 24 without using the rotation sensor 43. For example, the cooling device 4 may be configured to obtain the rotation speed of the ventilator 41 or the ventilator 24 based on a change in the voltage supplied to the ventilator 41 or the ventilator 24 or a signal output from the ventilator 41 or the ventilator 24.

In Embodiments 1 and 2, the bearing of the ventilator 41 or the ventilator 24 is an oil bearing 45, but the bearing of the ventilator 41 or the ventilator 24 may be a bearing other than the oil bearing 45, such as a ball bearing, a roller bearing, or a plain bearing. Lubricating oil is also used in bearings other than the oil bearing 45. In the ventilator 41 or ventilator 24 using a bearing other than the oil bearing 45, the lubricating oil may solidify, causing the bearing to stick and making the bearing unable to rotate. Therefore, the process for resolving sticking of the bearing and the process for preventing sticking of the bearing are also useful for the ventilator 41 or the ventilator 24 that uses a bearing other than the oil bearing 45.

The present invention is not limited to the above-described embodiment, and various modifications are possible within the scope of the claims. In other words, embodiments obtained by combining technical means that are appropriately modified within the scope of the claims are also included in the technical scope of the present invention.

The matters described in each embodiment can be combined with each other. Furthermore, the independent and dependent claims set forth in the claims can be combined with each other in any and all combinations, regardless of the form of reference. Furthermore, the claims are in a format in which a claim refers to two or more other claims (multiple claim format), but the present invention is not limited to this format. A multiple claim (multi-multi claim) may be written using a format that cites at least one multiple claim.

### DESCRIPTION OF CODES

1. ADAS device
2. Vehicle
21. Vehicle equipment
3. Control unit
30. Recording media
31. Calculation part
331. Computer Program
4. Cooling device
41. Ventilator
42. Voltage supply part
43. Rotation sensor
44. Temperature sensor
45. Oil bearing
51, 52. Computing device

## Claims

1. A cooling device for cooling a heat source in a vehicle, comprising:
a ventilator; and
a voltage supply part that supplies voltage to the ventilator, wherein
the voltage supply part supplies a voltage for rotating the ventilator to the ventilator, and when the rotational speed of the ventilator does not exceed a prescribed rotational speed, repeatedly performs supplying of the voltage to the ventilator and stopping of the supplying of the voltage.

2. The cooling device according to claim 1, wherein the voltage supply part periodically supplies a voltage for rotating the ventilator to the ventilator.

3. The cooling device according to claim 1, further comprising:
a control unit, wherein
the control unit causes the voltage supply part to supply a voltage for starting rotation of the ventilator to the ventilator when a prescribed condition is satisfied, and when the rotational speed of the ventilator does not exceed the prescribed rotational speed, causes the voltage supply part to repeatedly perform supply of voltage and stoppage of the voltage to the ventilator until the rotational speed of the ventilator exceeds the prescribed rotational speed, and causes the voltage supply part to supply a voltage to the ventilator for continuously rotating the ventilator when the rotational speed of the ventilator exceeds the prescribed rotational speed.

4. The cooling device according to claim 3, wherein the control unit causes the voltage supply part to periodically supply a voltage for rotating the ventilator to the ventilator when the prescribed condition is not satisfied.

5. The cooling device according to claim 3, wherein the prescribed condition is that prescribed equipment included in the vehicle is operating and a temperature of a prescribed portion within the vehicle exceeds a prescribed temperature.

6. The cooling device according to claim 3, wherein the heat source is an ADAS device that achieves functions of an ADAS (Advanced Driver Assistance System), and the prescribed condition is that prescribed equipment provided in the vehicle is operating and a temperature of a prescribed portion of the ADAS device exceeds a prescribed temperature.

7. The cooling device according to claim 1, wherein the ventilator includes an oil bearing.

8. A control method, comprising:
supplying a voltage for rotating a ventilator to the ventilator for cooling a heat source in a vehicle; and
repeating supply of the voltage to the ventilator and stopping supply of voltage when a rotational speed of the ventilator does not exceed a prescribed rotational speed.

9. A computer program for causing a computer to perform processing, comprising:
causing a voltage supply part to supply voltage for rotating a ventilator to the ventilator for cooling a heat source in a vehicle, and
causing the voltage supply part to repeatedly supply voltage and stop supply of voltage to the ventilator if the rotation speed of the ventilator does not exceed a prescribed rotation speed.
